**Europäisches Patentamt**

**European Patent Office**

**Office européen des brevets**

(19)

(11) Veröffentlichungsnummer: **0 625 710 A2**

## (12) EUROPÄISCHE PATENTANMELDUNG

(21) Anmeldenummer: **94107146.6**

(22) Anmeldetag: **06.05.94**

(51) Int. Cl.5: **G01R 31/00**

(30) Priorität: **21.05.93 DE 4317109**

(43) Veröffentlichungstag der Anmeldung:
**23.11.94 Patentblatt 94/47**

(84) Benannte Vertragsstaaten:
**DE ES FR GB**

(71) Anmelder: **Herion-Werke KG**
**Stuttgarter Strasse 120**
**D-70736 Fellbach (DE)**

(72) Erfinder: **Ehrenfried, Dittrich, Dr. Dipl.-Phys.**
**Raiffeisenstrasse 12**
**D-73035 Göppingen (DE)**

(74) Vertreter: **Leyh, Hans, Dr.-Ing.**
**Patentanwälte**
**Berendt, Leyh & Hering**
**Innere Wiener Strasse 20**
**D-81667 München (DE)**

(54) Verfahren zur Überprufung von Magnetventilen und zugehörige Messanordnung.

(57) Die Erfindung betrifft ein Verfahren zur sicherheitstechnischen Überprüfung von Magnetventilen, wobei während eines Arbeitsspiels des Magnetventiles der Erregerstrom des Betätigungsmagneten des Ventiles über der Zeit als Meßfunktion I = I(t) erfaßt und gespeichert wird. Aus der Meßfunktion wird dann die Kontrollfunktion I' = dI/dt digital erzeugt und nach digitaler Logarithmierung ebenfalls gespeichert. Beide Funktionen können gleichzeitig auf einem Bildschirm dargestellt und verglichen werden, wodurch eine bessere und genauere Bewertung des Funktionszustandes des betreffenden Magnetventiles einschließlich eventueller Fehler ermöglicht wird.

FIG. 1

EP 0 625 710 A2

Die Erfindung betrifft ein Verfahren zur sicherheitstechnischen Überprüfung von Magnetventilen. Sie betrifft ferner eine Meßanordnung zur Durchführung eines solchen Verfahrens.

Gemäß der Deutschen Offenlegungsschrift DE 38 07 278 A1 wird bei der sicherheitstechnischen Überprüfung von Magnetventilen die Änderung des Erregerstroms über der Zeit $I' = dI/dt$ unter logarithmischer Verstärkung erfaßt und gespeichert. Durch Speicherung und Vergleich von zeitlich aufeinanderfolgenden Messungen ist eine Bewertung des Funktionszustandes des betreffenden Magnetventiles möglich.

Nachteilig hierbei ist, daß eine automatisierte Erfassung der Kontrollfunktion $I' = dI/dt$ sehr aufwendig ist.

Der Erfindung liegt daher die Aufgabe zugrunde, ein Verfahren zur sicherheitstechnischen Überprüfung von Magnetventilen und eine entsprechende Meßanordnung zu schaffen, die eine bessere Bewertung des Funktionszustandes des jeweiligen Magnetventiles ermöglichen.

Nach der Erfindung wird dies dadurch erreicht, daß während eines Arbeitsspiels des Magnetventils der Erregerstrom des Betätigungsmagneten des Ventils über der Zeit als Meßfunktion $I = I(t)$ erfaßt, digital gespeichert und gegebenenfalls angezeigt wird.

Vorzugsweise wird dann aus der Meßfunktion die Kontrollfunktion $I' = dI/dt$ digital erzeugt und nach digitaler Logarithmierung digital gespeichert und gegebenenfalls angezeigt.

Eine bevorzugte Meßanordnung zur Durchführung dieses Verfahrens, bei welcher der Betätigungsmagnet an eine Spannungsquelle angeschlossen ist, zeichnet sich dadurch aus, daS in einer Verbindungsleitung zwischen der Spannungsquelle und dem Betätigungsmagneten als Meßwertaufnehmer ein Meßwiderstand liegt, zu welchem ein Verstärker parallel geschaltet ist, dessen Signalausgang über einen Analog/Digital-Wandler an einen Mikroprozessor zur Datenzwischenspeicherung gelegt ist, der seinerseits mit einem Meßrechner zur Datenspeicherung und einer Anzeigeeinrichtung verbunden ist.

Vorteilhaft bei dem erfindungsgemäßen Verfahren ist es, daS sich eine automatisierte Erfassung des Erregerstromes sehr viel einfacher gestaltet als eine automatisierte Erfassung der Kontrollfunktion. Der maximale Erregerstrom und somit die Dimensionierung der zur Erfassung des Erregerstromes benötigten elektronischen Komponenten können aus den Magnetdaten bestimmt und mittels einer Testmessung automatisch exakt festgelegt werden, während zur Auswahl der elektronischen Komponenten für eine elektrisch-induktive Messung mehrere Testmessungen nötig sind. Ein weiterer Vorteil liegt darin, daß durch die gleichzeitige Darstellung der Meßfunktion $I = I(t)$ und der *Kontrollfunktion $I' = dI/dt$ auf einem Bildschirm mehrere Eigenschaften eines Magnetventiles erkannt werden können, wie z.B. Bewegungsbeginn (Anzug-und Abfallverzugszeit), Bewegungsende (Hub-, Anzugs- und Abfallzeit), die Stromwerte bei Bewegungsbeginn (Anzugs- und Abfallstrom) und das Bewegungsverhalten des Magnetankers bzw. des Magnetventils während des gesamten Hubes.

Durch Kenntnis dieser Eigenschaften können schnell und einfach Aussagen über den Funktionszustand und die Auslegung eines Magnetventils gemacht werden.

So läßt sich aus der logarithmierten Kontrollfunktion der Beginn der mechanischen Bewegung bestimmen. Die logarithmierte Kontrollfunktion zeigt zunächst ein nahezu lineares Verhalten. Das Verlassen dieses linearen Verlaufs zeigt den Beginn der mechanischen Bewegung im Magnetventil an. Bei bekannter Verzugszeit kann nun aus der Stromkurve $I = I(t)$ der Stromwert bei Bewegungsbeginn ermittelt werden.

Das Bewegungsende und das Bewegungsverhalten des Magnetankers während des Hubes können aus beiden Kurven erkannt werden.

Da jedoch der mechanische Schaltvorgang in Stromverlauf $I = I(t)$ einfacher zu erkennen ist als in der logarithmierten Kontrollfunktion $I' = dI/dt$, kann aus dem Kurvenverlauf gegebenenfalls auch die Ursache eines Defekts erkannt werden. Durch die direkte Speicherung der Meßfunktion $I = I(t)$ besteht im Gegensatz zu den bisherigen Verfahren jederzeit die Möglichkeit, beliebige Analysen der Meßfunktion durchzuführen.

Eine beispielsweise Ausführungsform der Erfindung wird nachfolgend anhand der Zeichnung erläutert, in der

FIGUR 1
schematisch eine Meßanordnung nach der Erfindung zeigt.

FIGUR 2
zeigt den Kurvenverlauf der Meßfunktion $I = I(t)$.

FIGUR 3
zeigt die logarithmierte Kontrollfunktion $I' = dI/dt$.

FIGUREN 4 und 5
zeigen die Meßfunktion $I = I(t)$ und die logarithmierte Kontrollfunktion $I' = dI/dt$ für ein Ventil, das während des Hubes eine ruckartige Bewegung, beispielsweise verursacht durch lokal erhöhte Reibung, zeigt.

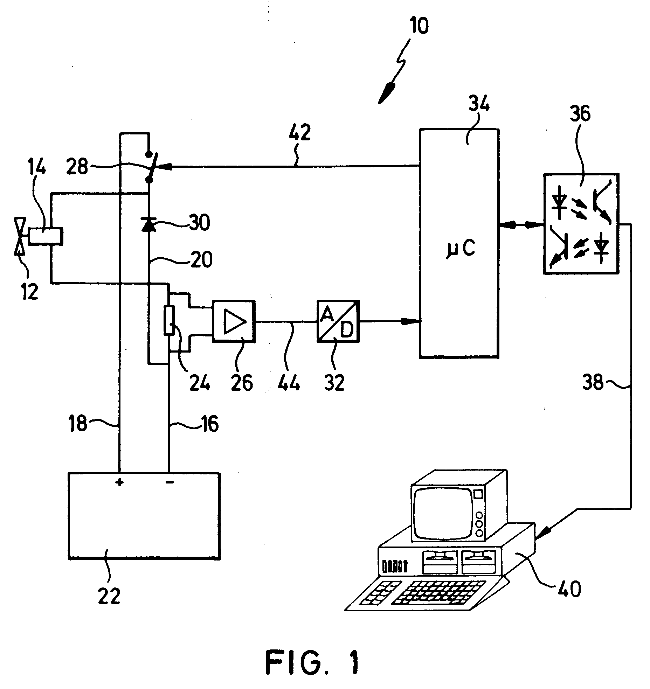

Figur 1 zeigt schematisch die Meßanordnung 10 zur sicherheitstechnischen Überprüfung eines Magnetventiles 12, das mit einem Betätigungsmagneten 14 versehen ist. Der Magnet 14 ist über

* logarithmierten

Verbindungsleitungen 16, 18, 20 an eine Spannungsquelle 22 angeschlossen.

In der Leitung 16 liegt ein Meßwiderstand 24, zu welchem ein Verstärker 26 parallel geschaltet ist. In der Leitung 18 liegt ein Schalter 28 zum An- und Abschalten des Betätigungsmagneten 14.

Die Leitung 20 verbindet die beiden Leitungen 16, 18, und sie erstreckt sich von einem Punkt vor dem Meßwiderstand 24 bis zu einem Punkt hinter dem Schalter 28. In der Leitung 20 liegt eine Diode 30, die so zwischen die beiden Leitungen 16, 18 der Stromzuführung geschaltet ist, das nach dem Öffnen des Schalters 28 ein Stromkreis entsteht, bestehend aus dem Betätigungsmagnet 14, der Diode 30 und dem Meßwiderstand 24.

Der Signalausgang des Verstärkers 26 ist über eine Leitung 44 an den Eingang eines Analog/Digital-Wandlers 32 gelegt, dessen Ausgang an einen Mikroprozessor 34 geschaltet ist. Der Mikroprozessor 34 ist über eine Schnittstelle 36 und eine Leitung 38 an einen Meßrechner 40 angeschlossen, der ein handelsüblicher, mit Bildschirm versehener Personal-Computer sein kann.

In der in Figur 1 dargestellten Schaltung ist der Schalter 28 geöffnet. Er wird durch den Mikroprozessor 34 über eine Leitung 42 angesteuert, das heißt geöffnet und geschlossen. Die für den jeweiligen Betätigungsmagneten 14 geeignete Größe des Meßwiderstandes 24 wird aus den Magnetdaten bestimmt, wobei der Widerstandswert des Meßwiderstandes 24 bis etwa 2% des Widerstandes des Betätigungsmagneten 14 betragen kann.

Wenn der Schalter 28 geschlossen wird, ist der Betätigungsmagnet 14 an die Spannungsquelle 22 angeschlossen und der durch den Meßwiderstand 24 fließende Erregerstrom läßt an letzterem einen Spannungsabfall entstehen, der über den Verstärker 26 und den A/D-Wandler 32 an den Mikroprozessor 34 übertragen und dort über der Zeit zwischengespeichert wird. Die Meßdaten werden dann vom Mikroprozessor 34 über die Schnittstelle 36 an den Meßrechner 40 übertragen, in welchem aus den Meßdaten die Meßfunktion I = I(t) gebildet und gespeichert wird. Auf dem Bildschirm des Meßrechners 40 kann die Meßfunktion I = I(t) dargestellt werden.

Beim Ausschalten wird der Schalter 28 geöffnet. Der Strom fließt nun über den Meßwiderstand 24 und die Löschdiode 30. Die Aufnahme der Meßfunktion I = I(t) erfolgt entsprechend dem oben beschriebenen Einschaltvorgang.

Die Steuerung der Messung erfolgt über den Mikroprozessor 34, der seinerseits vom Meßrechner 40 gesteuert wird.

Die mathematische, digitale Aufbereitung der Meßfunktion I = I(t), das heißt die Erzeugung der Kontrollfunktion I' = dI/dt kann sofort nach Übertragung der Meßdaten auf den Meßrechner 40 erfolgen, worauf sie nach der digitalen Logarithmierung auf einem Speichermedium (Diskette, Festplatte) abgelegt wird, oder sie wird erst bei Bedarf aus der Meßfunktion I = I(t) gebildet.

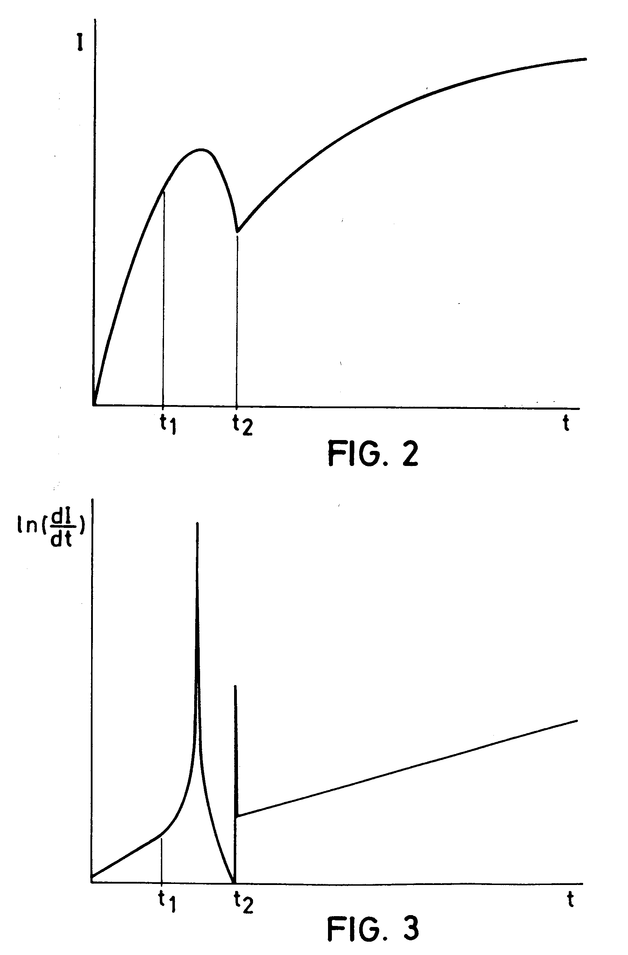

In Figur 2 ist der Kurvenverlauf der Meßfunktion I = I(t) dargestellt. Diese Meßfunktion erhält man, wenn der zum Betätigungsmagneten fließende Strom mit der erfindungsgemäßen Meßanordnung gemessen wird. Die Zeit t1 wird als Ansprechverzug bezeichnet, und sie gibt an, wann sich der Magnetanker des Betätigungsmagneten zu bewegen beginnt. Die Bewegung des Magnetankers ist nach der Anzugszeit t2 beendet. Die Differenz t2-t1 stellt die Hubzeit dar. Der Ausschaltvorgang kann entsprechend beschrieben werden. In der Meßfunktion I = I(t) kann jedoch der Zeitpunkt, an dem sich der Magnetanker zu bewegen beginnt (Ansprechverzug t1) nicht erkannt werden.

In Figur 3 jedoch, welche die logarithmierte Kontrollfunktion I' = dI/dt zeigt, ist der Ansprechverzug t1 deutlich daran zu erkennen, daß die Kurve ihren nahezu linearen Verlauf rasch verläßt. Die Anzugszeit t2 ist durch die letzte Spitze im Kurvenverlauf zu erkennen. Alle Spitzen bedeuten Nullstellen der Kontrollfunktion I' = dI/dt.

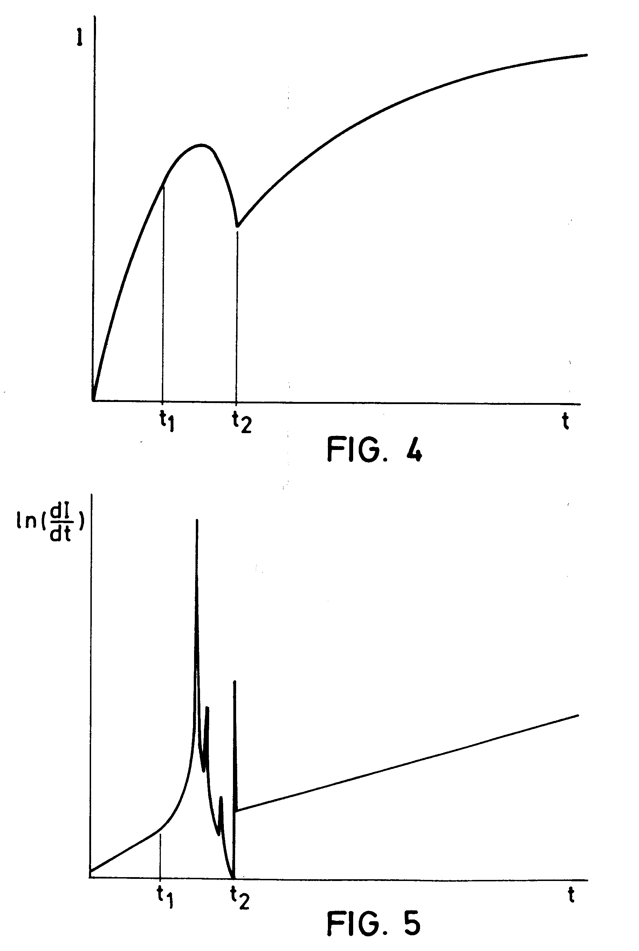

Die Figuren 4 und 5 zeigen die Meßfunktion I = I(t) und die logarithmierte Kontrollfunktion I' = dI/dt für ein Ventil, das während des Hubes eine ruckartige Bewegung zeigt, beispielsweise verursacht durch eine lokal erhöhte Reibung. Dies ist in Figur 4 (Meßfunktion I = I(t)) durch zwei leichte Wellen nur schwer zu erkennen, während die logarithmierte Kontrollfunktion I' = dI/dt gemäß Figur 5 dies durch zwei weitere Spitzen (im Vergleich zu Figur 3) sehr deutlich anzeigt. Ursache für eine solche erhöhte Reibung können beispielsweise Ablagerungen oder Korrosion sein.

**Patentansprüche**

1. Verfahren zur sicherheitstechnischen Überprüfung von Magnetventilen, **dadurch gekennzeichnet,** daß während eines Arbeitsspiels des Magnetventils der Erregerstrom des Betätigungsmagneten des Ventils über der Zeit als Meßfunktion I = I(t) erfaßt, digital gespeichert und gegebenenfalls angezeigt wird.

2. Verfahren nach Anspruch 1, **dadurch gekennzeichnet,** daß aus der Meßfunktion die Kontrollfunktion I' = dI/dt digital erzeugt und nach digitaler Logarithmierung digital gespeichert und gegebenenfalls angezeigt wird.

3. Meßanordnung zur Durchführung des Verfahrens nach Anspruch 1 oder 2, wobei der Betätigungsmagnet an eine Spannungsquelle angeschlossen ist, **dadurch gekennzeichnet,** daß in einer Verbindungsleitung (16) zwischen der Spannungsquelle (22) und dem Betätigungsmagneten (14) als Meßwertaufnehmer ein Meßwiderstand (24) liegt, zu welchem ein Verstärker (26) parallel geschaltet ist, dessen Signalausgang über einen Analog/Digital-Wandler (32) an einen Mikroprozessor (34) zur Datenzwischenspeicherung gelegt ist, der seinerseits mit einem Meßrechner (10) zur Datenspeicherung und einer Anzeigeeinrichtung verbunden ist.

FIG. 1

I

t₁   t₂   t

## FIG. 2

$\ln\left(\frac{dI}{dt}\right)$

t₁   t₂   t

## FIG. 3

FIG. 4

FIG. 5